# EUROPÄISCHE PATENTSCHRIFT

(11) **EP 1 000 918 B1**
(45) Veröffentlichungstag und Bekanntmachung des Hinweises auf die Patenterteilung: **22.03.2006**
(21) Anmeldenummer: 99119836.7
(22) Anmeldetag: 07.10.1999
(51) Int. Cl.: C07B 61/00, G01N 24/08, G01R 33/465, G01R 33/46

(54) **Verfahren zum Verifizieren der Synthese organischer Moleküle in der kombinatorischen Chemie**
Process for checking the synthesis of organic molecules in combinatorial chemistry
Procédé de vérification de la synthèse de molécules organiques en chimie combinatoire

(30) Priorität: 26.10.1998 DE 19849231
(43) Veröffentlichungstag der Anmeldung: 17.05.2000
(73) Patentinhaber: Bruker BioSpin GmbH, 76287 Rheinstetten (DE)
(72) Erfinder: Schröder, Harald, Dr., 76576 Weil am Rhein (DE); Neidig, Klaus-Peter, Dr., 76275 Ettlingen (DE)
(74) Vertreter: Kohler Schmid Möbus

(56) Entgegenhaltungen:
- WILL M ET AL: "Fully automated structure elucidation - A spectrocopist's dream comes true" JOURNAL OF CHEMICAL INFORMATION AND COMPUTER SCIENCES, AMERICAN CHEMICAL SOCIETY, Bd. 36, 1996, Seiten 221-227, XP002290864
- CZARNIK A W: "COMBINATORIAL" ANALYTICAL CHEMISTRY, AMERICAN CHEMICAL SOCIETY. COLUMBUS, US, 1. Juni 1998 (1998-06-01), Seiten 378A-386A, XP000856269 ISSN: 0003-2700
- ROSS¹ G ET AL: "Automated structure verification of small molecules libraries using 1D and 2D NMR techniques" METHODS IN MOLECULAR BIOLOGY (CLIFTON, N.J.), UNITED STATES, Bd. 201, 2002, Seiten 123-140, XP009034685

## Beschreibung

Die Erfindung betrifft ein Verfahren zum Verifizieren der Synthese von aus Substrukturen aufgebauten organischen Molekülen der kombinatorischen Chemie.

Verfahren der kombinatorischen Chemie zur automatischen Synthetisierung einer großen Zahl von neuen organischen Molekülen aus an sich bekannten Substrukturen und anschließende Verifikation des Erfolgs oder Mißerfolgs der Synthese sind beispielsweise bekannt aus dem Artikel "COMBINATORIAL" von A. W. Czarnik in der Zeitschrift Analytical Chemistry News & Features, Seiten 378 A bis 386 A, 1. Juni 1998, der ein Verfahren gemäß dem Oberbegriff des Anspruchs 1 offenbart.

Die kombinatorische Chemie ist ein Untergebiet der Chemie, das darauf abzielt, eine kleine Anzahl von chemischen Reagentien, in allen durch ein gegebenes Reaktionsschema definierten Kombinationen zu synthetisieren, um eine große Anzahl von wohldefinierten Produkten zu erhalten.

Insbesondere besteht in der kombinatorischen Chemie ein großer Bedarf für NMR-Messungen mit hohem Durchsatz zur Verifizierung der synthetisierten Produkte. Die Auswertung der gemessenen NMR-Spektren wurde bisher "von Hand" durch hochspezialisierte Chemiker im wesentlichen intuitiv durchgeführt oder basierte auch auf im Ergebnis relativ ungenauen Modellrechnungen.

Aufgabe der vorliegenden Erfindung ist es daher, ein Verfahren der eingangs genannten Art vorzustellen, mit dem eine schnelle, reproduzierbare und zuverlässige Verifizierung einer großen Anzahl von synthetisierten Produkten der kombinatorischen Chemie ermöglicht wird.

Erfindungsgemäß wird diese Aufgabe durch ein Verfahren gemäß Anspruch 1 gelöst.

Die zeitliche Abfolge der Verfahrensschritte (A) bis (F) läuft bevorzugt in der obengenannten Reihenfolge ab, kann jedoch auch in einer sinnvoll geänderten anderen Reihenfolge ablaufen. Andere Verfahrensschritte wiederum, die auf vorhergehenden Verfahrensschritten zwingend aufbauen, können natürlicherweise nur in einer bestimmten Abfolge abgearbeitet werden. Beispielsweise kann die Überprüfung der NMR-Spektren in Schritt (E) erst dann erfolgen, wenn vorher die NMR-Spektren in Schritt (C) aufgenommen wurden.

Der Begriff der "mehrdimensionalen" NMR-Spektren schließt natürlich auch eindimensionale NMR-Spektren ein.

Bei einer bevorzugten Variante des erfindungsgemäßen Verfahrens schließt sich an Schritt (F) ein Schritt (G) gemäß Anspruch 2 an.

Dadurch kann zunächst neben den positiv erkannten, wunschgemäß gelaufenen Synthesen, die in Schritt (F) mit "wahr" charakterisiert wurden, sehr schnell aus den übrigen Spektren diejenige Probe aussortiert werden, bei denen die Synthese nicht oder nicht vollständig funktioniert hat und daher zumindest eine der Signalgruppen im NMR-Spektrum nicht vorhanden ist. Für die als "falsch" charakterisierten Kombinationen kann anschließend entweder nochmals der Versuch einer Synthese aus den entsprechenden chemischen Ausgangssubstanzen gemacht werden, um sicherzustellen, daß die offenbar unvollständige Synthese beim ersten Mal nicht etwa auf einem Fehler im Syntheseverfahren beruht hat. Alternativ kann aber auch bei einer sehr großen Anzahl von zu bearbeitenden Kombinationen auf eine weitere Betrachtung der als "falsch" charakterisierten Kombinationen, die offenbar nicht ohne weiteres zu synthetisieren sind, ganz verzichtet werden.

In einer Weiterbildung kann sich an den Schritt (G) ein Schritt (H) gemäß Anspruch 3 anschließen.

Bei dieser Gruppe von Kombinationen waren offenbar alle Substrukturen an dem synthetisierten organischen Gesamtmolekül nachgewiesen worden, jedoch darüberhinaus auch noch weitere, die eigentlich nicht erwartet wurden. Hier könnte beispielsweise ein Hinweis auf unrichtig abgelaufene Syntheseverfahren oder anderweitige Meßfehler vorliegen, die beispielsweise zu Artefakten in den NMR-Spektren geführt haben könnten. Diese Fragen müßten bei Interesse anschließend von einem Spezialisten anhand der "unklaren" NMR-Spektren geklärt werden.

Ganz besonders bevorzugt ist eine Variante des erfindungsgemäßen Verfahrens gemäß Anspruch 4.

Der repräsentative Satz von Kombinationen wird in der Regel erheblich kleiner sein als die Gesamtanzahl aller möglichen Kombinationen, so daß die Überprüfung der NMR-Spektren der restlichen Kombinationen erheblich beschleunigt werden kann. Voraussetzung hierfür ist natürlich, daß auch tatsächlich eine eindeutige Zuordnung jeder im Produktmolekül einer Kombination enthaltenen Substruktur zu einer Signalgruppe des repräsentativen Satzes möglich ist. Falls dies nicht der Fall sein sollte, muß in Schritt (D₃') der repräsentative Satz geändert werden und ein erneuter Versuch einer eindeutigen Zuordnung in Schritt (D₂') erfolgen. Erst wenn die Zuordnung eindeutig ist, können in Schritt (E') sämtliche restlichen NMR-Spektren mit Hilfe der Signalgruppen des repräsentativen Satzes mit dem Ziel der Verifizierung der jeweiligen Synthese überprüft werden.

Eine Weiterbildung dieser bevorzugten Verfahrensvariante zeichnet sich dadurch aus, daß der repräsentative Satz in Schritt (D₁') durch Modifikation eines repräsentativen Satzes von Kombinationen aus einer früheren Meßreihe abgeleitet wird. Da in den meisten Fällen bereits Erfahrungen mit ähnlichen oder sogar gleichen Substrukturen vorliegen, können diese für einen "inital guess" für einen repräsentativen Satz von Kombinationen herangezogen werden, der mit höherer Wahrscheinlichkeit dem Kriterium einer eindeutigen Zuordnung von Signalgruppen zu den einzelnen Substrukturen genügen wird.

Vorzugsweise wird die Anzahl der im repräsentativen Satz enthaltenen Kombinationen minimiert, um die Überprüfung der restlichen NMR-Spektren nach dem erfindungsgemäßen Verfahren beschleunigen zu können. Falls die Substrukturen in Gruppen mit gleichem oder ähnlichem chemischen Verhalten aufgeteilt werden können, entspricht die kleinste denkbare Anzahl der im repräsentativen Satz enthaltenen Kombinationen der größten Anzahl von Substrukturen in einer Gruppe.

Die Zuordnung in Schritt (D₂') kann bei Varianten des erfindungsgemäßen Verfahrens manuell erfolgen, wobei dann keine spezielle Auswertesoftware erforderlich wird.

Alternativ kann die Zuordnung aber auch automatisiert mittels eines Rechners erfolgen, der im Gegensatz zur "Handauswertung" erheblich schneller arbeitet, wobei teures, hochqualifiziertes Bedienungspersonal für die eigentliche Auswertung eingespart wird und die Überprüfung objektiv, mit sehr hoher Wahrscheinlichkeit fehlerfrei und reproduzierbar durch die Maschine erfolgt.

Vorzugsweise werden die zu synthetisierenden organischen Moleküle niedermolekular sein und in der Regel in einem Molekulargewichtsbereich von etwa 100 u bis etwa 2000 u liegen. Dies ist ein für die kombinatorische Chemie bevorzugter Massenbereich. Für die NMR-Messungen sind in diesem Bereich interessierende Substrukturen als Ausgangssubstanzen in ausreichenden Mengen vorhanden. Außerdem sind zweidimensionale NMR-Spektren in diesem Molekulargewichtsbereich noch relativ übersichtlich.

Besonders bevorzugt enthält das synthetisierte organische Gesamtmolekül einen im folgenden mit "Core" bezeichneten Abschnitt, der bei allen Kombinationen identisch vorhanden ist und folglich in den NMR-Spektren aufgrund der gleichen Signalgruppen charakterisierbar ist, so daß es als interne Referenz im Sinne einer Standardintensität herangezogen werden kann. Das Core kann entweder vor der Synthese als eigenes Reagens zugegeben werden, wobei sich dann die anderen Substrukturen daran anlagern, oder es kann in einem Bindungsbereich der Substrukturen von diesen selbst als gemeinsamer Abschnitt des Moleküls gebildet werden.

Vorzugsweise ist das Core eine Substruktur, die zwischen zwei und sechs chemische Bindungsstellen aufweist. Damit bleibt die mögliche Kombinatorik hinreichend übersichtlich. Außerdem ist für diese Art von Substrukturen eine Vielzahl von handelsüblichen Substanzen als Core einsetzbar.

Bei einer ganz besonders bevorzugten Weiterbildung der oben beschriebenen erfindungsgemäßen Verfahrensvarianten sind die Substrukturen zu Gruppen zusammengefaßt, die jeweils einer Bindungsstelle des Core zugeordnet sind.

Die Anzahl der interessierenden Substrukturen sollte nicht wesentlich über 500 liegen, damit die Kombinatorik zuverlässig mit relativ hoher "Trefferwahrscheinlichkeit" ablaufen kann, andererseits aber deutlich über drei liegen, damit ein kombinatorischer Ansatz überhaupt sinnvoll wird.

Im einfachsten Fall ist das NMR-Spektrum eindimensional.

Besonders bevorzugt werden die NMR-Spektren zweidimensional sein, insbesondere HSQC-SpeKtren (= hetero nuclear single quantum coherence, siehe z.B. J.Magn.Reson. B108, S.94-98 (1995)). Zweidimensionale NMR-Spektren lassen sich in endlich kurzen Meßzeiten in der Größenordnung von Minuten mit hinreichend genauer Auflösung im Gegensatz zu lediglich eindimensionalen Spektren erzeugen.

Ganz besonders bevorzugt sind auch Varianten des erfindungsgemäßen Verfahrens, bei denen das mehrdimensionale NMR-Spektrum die Atomkerne ¹H und ¹³C umfaßt. Damit sind die beiden wichtigsten Atomsorten der organischen Chemie, die nämlich dieses Untergebiet überhaupt definieren, enthalten.

Um den Informationsgehalt der NMR-Spektren auf die wesentlichen relevanten Merkmale zu reduzieren, ist bei einer weiteren bevorzugten Verfahrensvariante vorgesehen, daß von den mehrdimensionalen NMR-Spektren Peaklisten zur Definition der Signalgruppen erstellt werden.

Ein besonders einfaches Standardverfahren zur Peakerkennung besteht darin, daß ein Datenpunkt des mehrdimensionalen, vorzugsweise zweidimensionalen NMR-Spektrums als "Peak" erkannt wird, wenn sein Wert größer als der von n Nachbardatenpunkten ist, wobei vorzugsweise n=8.

In einer bevorzugten Weiterbildung werden benachbarte Peaks zu Clustern zusammengefaßt und mittels Clusteranalyse ausgewertet, wobei ein oder mehrere Cluster als Signalgruppen den interessierenden Substrukturen zugeordnet werden. Damit wird eine flächenartige Definition der Signalgruppen ermöglicht. Diese Methode ist unempfindlich gegen die Feinstruktur der einzelnen Peaks, die dabei außer Acht gelassen werden kann. Die Clusteranalyse als solche ist beispielsweise beschrieben in K.-P. Neidig et al., Journal of Magnetic Resonance 89, Seiten 543 bis 552 (1990).

Eine besonders bevorzugte Weiterbildung dieser Verfahrensvariante zeichnet sich dadurch aus, daß jedem Cluster ein Areal (Cluster Fläche im zweidimensionalen NMR-Spektrum oder Hyperfläche im mehrdimensionalen Fall) zugeordnet wird, und daß eine Substruktur als erkannt gilt, wenn für alle ihr zugeordneten Cluster-Flächen gilt, daß das über die Cluster-Fläche integrierte NMR-Signal einen vorgegebenen Schwellwert überschreitet. Damit ist eine sehr zuverlässige Bilderkennung, insbesondere ein Erfassen von Substrukturen im NMR-Spektrum möglich.

Der Schwellenwert kann im einfachsten Fall als Konstante gewählt werden. Vorteilhafterweise wird der Schwellwert proportional zum Integral des NMR-Signals über Clusterflächen gewählt, die anderen interessierenden Substrukturen zugeordnet sind. Dies ermöglicht eine Normierung der jeweiligen Signalgruppe, die insbesondere für eine Core-Substruktur wünschenswert ist. Der Schwellwert ist dann unabhängig von absoluten Meßwerten der Spektren.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand eines Ausführungsbeispiels näher erläutert. Es zeigen:
- Fig. la: eine schematische Darstellung einer aus den Substrukturen Aₓ + B_{y} + C_{z} aufgebauten Kombination eines organischen Moleküls, wobei die Substrukturen ein gemeinsames Core bilden;
- Fig. 1b: eine schematische Darstellung einer aus den Substrukturen Aₓ + B_{y} + C_{z} sowie einem Core-Molekül aufgebauten Kombination eines organischen Moleküls;
- Fig. 2: die in den Spektren der Figuren 3 bis 7 verwendeten Substrukturen in der Darstellungsweise der organischen Chemie; und

die Figuren 3 bis 7 jeweils ein NMR-Spektrum einer Kombination von drei Substrukturen Aₓ, B_{y}, C_{z} mit einem Core-Molekül, nämlich

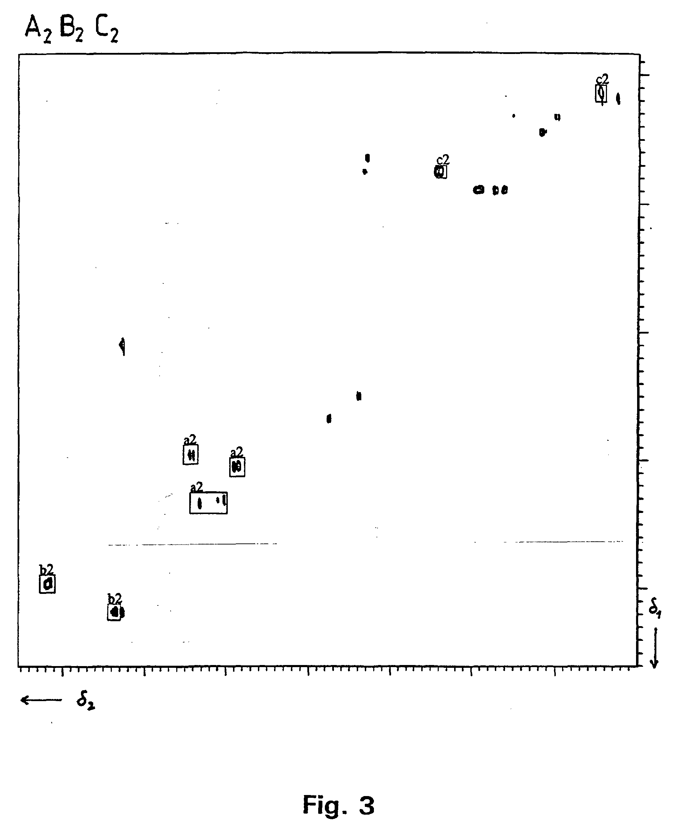

Fig. 3 A₂ + B₂ + C₂;

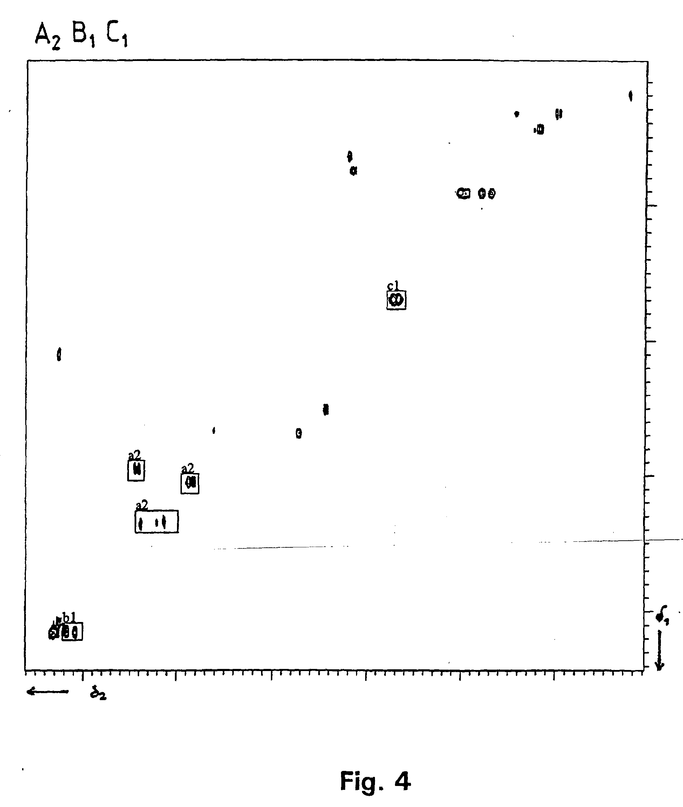

Fig. 4 A₂ + B₁ + C₁;

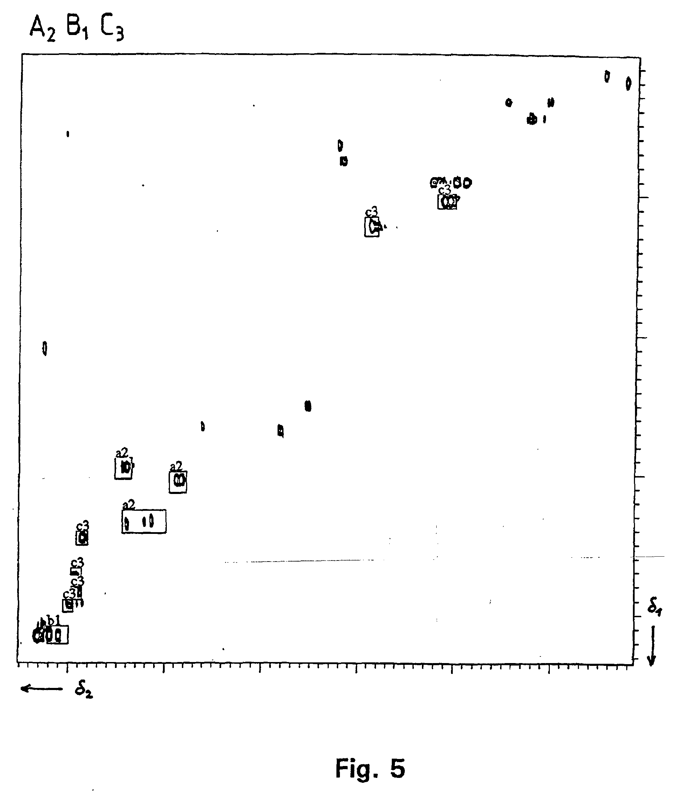

Fig. 5 A₂ + B₁ + C₃;

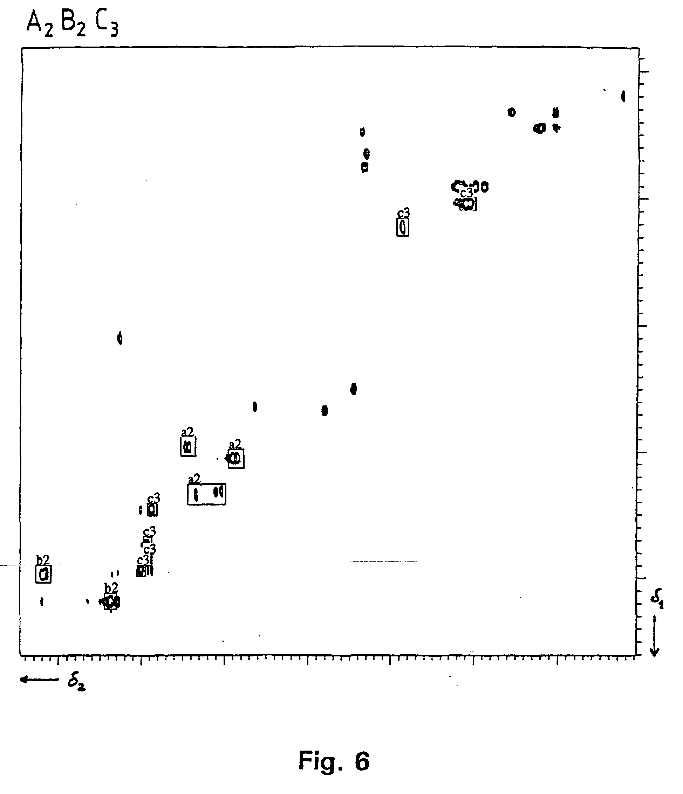

Fig. 6 A₂ + B₂ + C₃;

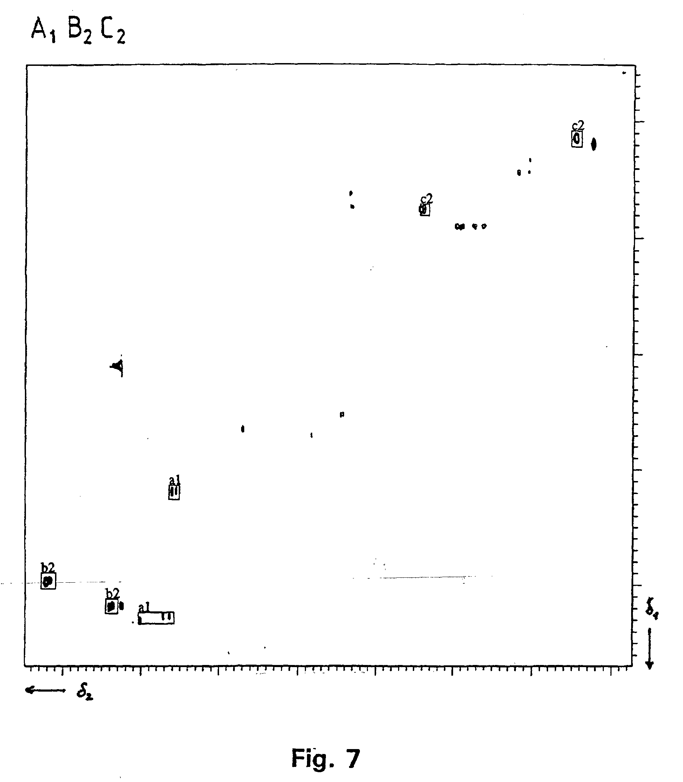

Fig. 7 A₁ + B₂ + C₂.

Chemische Verbindungen einer kombinatorischen Serie eignen sich besonders gut für eine automatische oder zumindest teilweise automatische Interpretation, da die Signale der Strukturen von kombinatorischen Serien formal zerlegt werden können in ein Core-Modul, das für alle Mitglieder der Serie gleich ist, und in einige wenige variable Moduln, die systematisch mit einer begrenzten Anzahl von strukturellen Fragmenten innerhalb der kombinatorischen Serie durchvariiert werden.

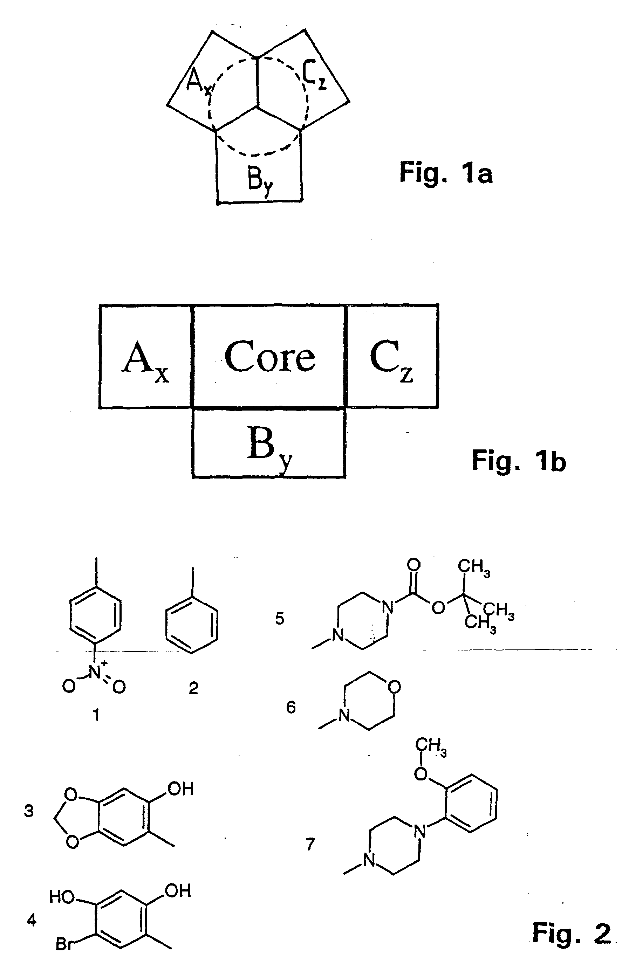

In Fig. 1a ist sehr schematisch ein solches organisches Molekül dargestellt, das aus drei Substrukturen Aₓ, B_{y} und C_{z} aufgebaut ist, welche im Bereich ihrer gegenseitigen Bindungen einen in Fig. 1a gestrichelt dargestellten gemeinsamen Core-Abschnitt bilden.

Alternativ kann, wie in Fig. 1b dargestellt, das organische Gesamtmolekül aber auch aus einem eigenen Core-Untermolekül mit drei daran anhängenden Substrukturen Aₓ, B_{y} und C_{z} aufgebaut sein.

Diese Moleküle werden üblicherweise mit Hilfe von Strukturcodes beschrieben, die aus Substrukturelementen mit den entsprechenden Substrukturcodes Aₓ, B_{y} und C_{z} usw. bestehen. Die Indizes x, y, z bedeuten jeweils eine fortlaufende Numerierung in natürlichen Zahlen (1, 2, 3...).

Derartige Substrukturelemente können, wie unten gezeigt wird, als Signale oder Signalgruppen in zweidimensionalen HSQC-Spektren identifiziert werden. Die für die in den Figuren 3 bis 7 gezeigten Beispiele verwendeten Substrukturen sind chemische Substanzen, die in Fig. 2 entsprechend der Darstellungsweise der organischen Chemie abgebildet sind. Dabei bedeuten:

| | |
|---|---|
| (1) 4-Nitro-phenyl | = B2 |
| (2) Phenyl | = B1 |
| (3) 3,4.methylendioxy-phenoxy | = A2 |
| (4) 3-Hydroxy,4-bromo-phenoxy | = A1 |
| (5) tert-Butyloxycarbonyl-piperazyl | = C2 |
| (6) Morpholinyl | = C1 |
| (7) 2-Methoxy-piperazyl | = C3 |

Bei den NMR-Experimenten, deren Ergebnisse in den Figuren 3 bis 7 gezeigt sind, handelt es sich um zweidimensionale, sogenannte HSQC (hetero nuclear single quantum coherence) Experimente. Angewandt auf Protonen und Kohlenstoff zeigen die Signale in diesen Spektren die Korrelationen zwischen Kohlenstoffatomen und den an ihnen chemisch gebundenen Protonen, und zwar die Kohlenstoffsignale in Richtung δ₁ und die Protonensignale in Richtung δ₂.

Das Auffinden der Signalgruppen, die zu einer bestimmten Substruktur gehören, kann manuell oder automatisiert durchgeführt werden. In der Automation führt man formal algebraische Additionen und Subtraktionen auf den Strukturcodes durch, ordnet jedem Code den Wert 1 zu und behält durch anschließende Schwellwertbildung den gewünschten Substrukturcode übrig, etwa:
"A₂ B₂ C₂"
"A₂ B₁ C₁"
"A₂ B₁ C₃"
"A₂ B₂ C₃"
"A₁ B₂ C₂"
dann kann durch Addition von
"A₂ B₁ C₃"
"A₂ B₂ C₃" und

### Subtraktion

"A₂ B₂ C₂"
"A₂ B₁ C₁"
"A₁ B₂ C₂"
das Ergebnis für A₁ A₂ B₁ B₂ C₁ C₂ C₃ -1 0 0 -1 -1 -2 2 erhalten werden. Setzt man einen Schwellwert 2, dann bleibt nur noch C₃ übrig.

Die allgemeine Regel lautet: Addiere alle Strukturcodes, die den gewünschten Substrukturcode enthalten, z.B. N, dann subtrahiere alle anderen, dann setze den Schwellwert auf N.

Diese formale Operation wird in der Praxis auf Peaklisten, die von den entsprechenden Spektren gewonnen wurden, durchgeführt. Ein Datenpunkt wird als zweidimensionaler Peak erkannt, wenn sein Wert größer als jeder der seiner 8 nächsten Nachbarn ist. Benachbarte Peaks können mit Hilfe einer Clusteranalyse, die paarweise Distanzen und Intensitäten auswertet, zu Gruppen (Cluster) zusammengefaßt werden.

Wird ein Peak eines Spektrum zu den Peaks eines anderen Spektrums addiert, so wird er in die dortige Liste aufgenommen und erhöht die Intensitäten aller Peaks, die innerhalb eines definierten Radius liegen.

Wird ein Peak eines Spektrums von den Peaks eines anderen Spektrums subtrahiert, so wird er aus der dortigen Liste entfernt und erniedrigt die Intensitäten aller Peaks, die innerhalb eines definierten Radius liegen.

Als Ergebnis erhält man eine Liste von Peaks, die von den Signalen der gewünschten Substruktur herrühren. Da diese Signale in verschiedenen Spektren leicht unterschiedlich sein können, treten die Peaks mehrfach und in Gruppen auf. Die Gruppen, auch Cluster genannt, werden durch eine Clusteranalyse bestimmt.

Die für die gewünschte Substruktur erhaltenen Signale werden nun durch jeweils kleine Rechtecke repräsentiert, wobei jedes Rechteck genau ein Cluster enthält. Die Breite und Höhe dieser Areale entsprechen den erwarteten Variationen der Signale im gegebenen Satz von Spektren.

Bei der Überprüfung der restlichen Spektren wird eine Integration aller Substrukturen durchgeführt. Integration bedeutet hierbei Summation aller entsprechenden Datenpunkte. Außerdem wird in jedem Spektrum ein vordefiniertes Gebiet, welches keine Signale enthält, integriert und daraus ein Rauschwert berechnet. Der Rauschwert wird von allen Integralen abgezogen.

Optional können Signale der "Core"-Substruktur als Referenz definiert und gesondert integriert werden.

Optional können die Integralverhältnisse zwischen allen Arealen aller Substrukturen berechnet werden.

Eine Substruktur gilt als erkannt, wenn alle ihre Areale den Integrationswert > 0 annehmen.

Optional gilt eine Substruktur als erkannt, wenn alle ihre Areale im Verhältnis zu einer Referenz einen definierten Integrationswert überschreiten.

Optional gilt eine Substruktur als erkarinf, wenn alle Verhältnisse der Integrale aller ihrer Areale zu den Integralen aller anderen Areale aller anderen Substrukturen einen definierten Wert überschreiten.

Im gezeigten Ausführungsbeispiel war x = 2, y = 2 und z = 3. Daraus ergeben sich 2 · 2 · 3 = 12 kombinatorisch mögliche Kombinationen (Aₓ B_{y} C_{z}). Der minimale repräsentative Satz müßte mindestens drei Kombinationen umfassen, damit C₁, C₂ und C₃ jeweils repräsentiert sind.

Als Resultat der Messungen und ihrer Auswertung ergibt sich bei unserem Ausführungsbeispiel folgende Ergebnistabelle:

| Kombinationen | A₂B₂C₂ | A₂B₁C₁ | A₂B₁C₃ | A₂B₂C₃ | A₁B₂C₂ |
|---|---|---|---|---|---|
| A₁ | - | - | - | - | + |
| A₂ | + | + | + | + | - |
| B₁ | - | + | + | - | - |
| B₂ | + | - | - | + | + |
| C₁ | - | + | - | - | - |
| C₂ | + | - | - | - | + |
| C₃ | - | - | + | + | - |
| Core | + | + | + | + | + |
| Summe | 4 | 4 | 4 | 4 | 4 |
| Resultat | + | + | + | + | + |

## Patentansprüche

1. Verfahren zum Verifizieren der Synthese von aus Substrukturen aufgebauten organischen Molekülen der kombinatorischen Chemie, das die folgenden Schritte umfasst:
(A) Bereitstellung der zur Synthese der organischen Moleküle benötigten Substrukturen und Zuordnen von Substrukturcodes (Aₓ, B_{y}, C_{z});
(B) Synthese einer kombinatorischen Serie von organischen Molekülen, die diese Substrukturen enthalten, durch systematisches Kombinieren von unterschiedlichen Substrukturen und jeweilige Zuordnung eines Gesamtcodes (AₓB_{y}C_{z}) zu der jeweiligen Kombination;
(C) Aufnahme von NMR-Spektren der synthetisierten organischen Moleküle in der Art, dass zumindest für eine Teilmenge der im Schritt (B) ausgeführten Kombinationen jeweils ein NMR-Spektrum aufgenommen wird; **dadurch gekennzeichnet, dass** das Verfahren darüberhinaus die folgenden Schritte umfasst:
(D) eindeutige Zuordnung von Signalgruppen der NMR-Spektren zu den einzelnen Substrukturen durch formale Addition und Subtraktion von in Schritt (C) aufgenommenen NMR-Spektren in der Art, dass man durch die formale Addition und Subtraktion für jede der Substrukturen ein NMR-Spektrum erhält, das nur die Signalgruppen der jeweiligen Substruktur enthält;
(E) Überprüfung der NMR-Spektren von Kombinationen, wobei bei der Überprüfung das NMR-Spektrum der jeweiligen Kombination auf das Vorhandensein aller Signalgruppen des der jeweiligen Kombination zugeordneten Gesamtcodes anhand der in Schritt (D) erzeugten eindeutigen Zuordnung überprüft wird;
(F) falls die Überprüfung in Schritt (E) ergibt, dass genau die Signalgruppen im NMR-Spektrum der jeweiligen Kombination beobachtet wurden, die im Gesamtcode der jeweiligen Kombination enthalten sind, wird die jeweilige Kombination mit "wahr" charakterisiert.

2. Verfahren nach Anspruch 1, **dadurch gekennzeichnet, daß** sich der Schritt (G) anschließt:
(G) falls die Überprüfung gemäß Schritt (E) für eine bestimmte Kombination ergibt, daß mindestens eine Signalgruppe einer Substruktur, die im Gesamtcode der jeweiligen Kombination enthalten ist, im NMR-Spektrum der jeweiligen Kombination nicht beobachtet wurde, wird diese Kombination mit "falsch" charakterisiert.

3. Verfahren nach Anspruch 2, **dadurch gekennzeichnet, daß** sich der Schritt (H) anschließt:
(H) falls die Überprüfung gemäß Schritt (E) jeweilige für eine bestimmte Kombination ergibt, daß weder (F) noch (G) zutrifft, wird die jeweilige Kombination mit "unklar" charakterisiert.

4. Verfahren nach einem der vorhergehenden Ansprüche, **dadurch gekennzeichnet, dass**
(D1') die Auswahl eines repräsentativen Satzes von Kombinationen erfolgt, wobei der repräsentative Satz von Kombinationen alle vorkommenden Substrukturen zumindest einmal enthält; dass
(D2') die eindeutige Zuordnung gemäss Schritt (D) anhand der NMR-Spektren des repräsentativen Satzes von Kombinationen erfolgt; dass
(D3') die Auswahl eines geänderten repräsentativen Satzes von Kombinationen und Wiederholung ab Schritt (D2') erfolgt, falls sich nicht jeder Substruktur eindeutig eine Signalgruppe zuordnen lässt und dass
(E') die Überprüfung gemäss Schritt (E) für die restlichen, nicht dem repräsentativen Satz angehörigen Kombinationen erfolgt.

5. Verfahren nach Anspruch 4 **dadurch gekennzeichnet, daß** der repräsentative Satz in Schritt (D₁') durch Modifikation eines repräsentativen Satzes von Kombinationen aus einer früheren Meßreihe abgeleitet wird.

6. Verfahren nach Anspruch 4 oder 5, **dadurch gekennzeichnet, daß** die Anzahl der im repräsentativen Satz enthaltenen Kombinationen minimiert wird.

7. Verfahren nach einem der Ansprüche 4-6, **dadurch gekennzeichnet, daß** die Zuordnung in Schritt (D₂') manuell erfolgt.

8. Verfahren nach einem der Ansprüche 4 bis 6, **dadurch gekennzeichnet, daß** die Zuordnung in Schritt (D₂') automatisiert mittels eines Rechners erfolgt.

9. Verfahren nach einem der vorhergehenden Ansprüche, **dadurch gekennzeichnet, daß** die organischen Moleküle niedermolekular sind, vorzugsweise mit Molekulargewichten im Bereich von 100 u bis 2000 u.

10. Verfahren nach einem der vorhergehenden Ansprüche, **dadurch gekennzeichnet, daß** ein Teil des organischen Gesamtmoleküls (=Core) in allen Kombinationen identisch vorhanden ist.

11. Verfahren nach Anspruch 10, **dadurch gekennzeichnet, daß** das Core eine Substruktur ist, die zwischen zwei und sechs chemische Bindungsstellen aufweist.

12. Verfahren nach Anspruch 10 oder 11, **dadurch gekennzeichnet, daß** die Substrukturen zu Gruppen zusammengefaßt werden, die jeweils einer Bindungsstelle des Core zugeordnet sind.

13. Verfahren nach einem der vorhergehenden Ansprüche, **dadurch gekennzeichnet, daß** die Anzahl der interessierenden Substrukturen zwischen fünf und fünfhundert liegt.

14. Verfahren nach einem der vorhergehenden Ansprüche, **dadurch gekennzeichnet, daß** das NMR-Spektrum eindimensional ist.

15. Verfahren nach einem der vorhergehenden Ansprüche, **dadurch gekennzeichnet, daß** das NMR-Spektrum ein zweidimensionales, vorzugsweise ein HSQC-Spektrum (=hetero nuclear single quantum coherence) ist.

16. Verfahren nach einem der vorhergehenden Ansprüche, **dadurch gekennzeichnet, daß** das NMR-Spektrum die Atomkerne ¹H und ¹³C umfaßt.

17. Verfahren nach einem der vorhergehenden Ansprüche, **dadurch gekennzeichnet, daß** von den NMR-Spektren Peaklisten zur Definition der Signalgruppen erstellt werden.

18. Verfahren nach Anspruch 17, **dadurch gekennzeichnet, daß** ein Datenpunkt des vorzugsweise zweidimensionalen NMR-Spektrums als "Peak" erkannt wird, wenn sein Wert größer als der von n Nachbardatenpunkten ist, wobei vorzugsweise n=8.

19. Verfahren nach einem der Ansprüche 17 oder 18, **dadurch gekennzeichnet, daß** benachbarte Peaks zu Clustern zusammengefaßt und mittels Clusteranalyse ausgewertet werden, wobei ein oder mehrere Cluster als Signalgruppen den jeweiligen Substrukturen zugeordnet werden.

20. Verfahren nach Anspruch 19, **dadurch gekennzeichnet, daß** jedem Cluster ein Areal im NMR-Spektrum zugeordnet wird, und daß eine Substruktur als erkannt gilt, wenn für alle ihr zugeordneten Areale gilt, daß das über die zugeordneten Areale integrierte NMR-Signal einen vorgegebenen Schwellwert überschreitet.

21. Verfahren nach Anspruch 20, **dadurch gekennzeichnet, daß** der Schwellwert proportional ist zum Integral des NMR-Signals über Areale, die anderen Substrukturen zugeordnet sind.

## Claims

1. A method to verify the synthesis of organic molecules of combinatorial chemistry which are formed from sub-structures, comprising the following steps:
(A) provision of the sub-structures required for the synthesis of the organic molecules and assigning of sub-structure codes (Aₓ, B_{y}, C_{z});
(B) synthesis of a combinatorial series of organic molecules containing these sub-structures, by systematic combination of different sub-structures and each time assigning a total code (AₓB_{y}C_{z}) to the respective combination;
(C) recording NMR spectra of the synthesized organic molecules in such a manner that one NMR spectrum each is recorded at least for a subset of the combinations of step (B), **characterized in that** the method moreover comprises the following steps:
(D) unique assignment of signal groups of the NMR spectra to the individual sub-structures through formal addition and subtraction of NMR spectra recorded in step (C) in such a manner that formal addition and subtraction provides an NMR spectrum for each of the sub-structures, which contains only the signal groups of the respective sub-structure;
(E) examining the NMR spectra of combinations, wherein during examination, the NMR spectrum of the respective combination is examined for the existence of all signal groups of the total code assigned with the respective combination, using the unique assignment generated in step (D);
(F) if the examination in step (E) yields the result that exactly those signal groups in the NMR spectrum of the respective combination were observed which are contained in the total code of the respective combination, the respective combination is **characterized** to be "true".

2. The method according to claim 1, **characterized in that** it is followed by step (G):
(G) if the examination in accordance with step (E) yields the result for a certain combination that at least one signal group of a sub-structure which is contained in the total code of the respective combination was not observed in the NMR spectrum of the respective combination, this combination is **characterized** to be "false".

3. The method according to claim 2, **characterized in that** it is followed by step (H):
(H) if the examination in accordance with step (E) yields the result for a certain combination that neither (F) nor (G) is the case, the respective combination is **characterized** to be "vague".

4. The method according to any one of the preceding claims, **characterized in that**:
(D₁') a representative set of combinations is selected, wherein the representative set of combinations contains all occurring sub-structures at least once;
(D₂') unique assignment according to step (D) is effected on the basis of the NMR spectra of the representative set of combinations;
(D₃') if it is not possible to uniquely assign one signal group to each sub-structure, a modified representative set of combinations is selected and the sequence is repeated from step (D2'); and
(E') the remaining combinations that do not belong to the representative set are examined according to step (E).

5. The method according to claim 4, **characterized in that** the representative set of step (D₁') is derived by modifying a representative set of combinations from an earlier measuring series.

6. The method according to claim 4 or 5, **characterized in that** the number of combinations contained in the representative set is minimized.

7. The method according to any one of the claims 4 through 6, **characterized in that** the assignment in step (D₂') is performed manually.

8. The method according to any one of the claims 4 through 6, **characterized in that** the assignment in step (D₂') is performed automatically using a computer.

9. The method according to any one of the preceding claims, **characterized in that** the organic molecules have a low molecular weight, preferably of a molecular weight in the range from 100 u to 2000 u.

10. The method according to any one of the preceding claims, **characterized in that** part of the overall organic molecule (= core) is identically present in all combinations.

11. The method according to claim 10, **characterized in that** the core is a sub-structure having between two and six chemical binding sites.

12. The method according to claim 10 or 11, **characterized in that** the sub-structures are combined to groups, each being associated with a binding site of the core.

13. The method according to any one of the preceding claims, **characterized in that** the number of interesting sub-structures is between 5 and 500.

14. The method according to any one of the preceding claims, **characterized in that** the NMR spectrum is one-dimensional.

15. The method according to any one of the preceding claims, **characterized in that** the NMR spectrum is a two-dimensional, preferably a HSQC spectrum (=hetero nuclear single quantum coherence).

16. The method according to any one of the preceding claims, **characterized in that** the NMR spectrum comprises the atomic nuclei ¹H and ¹³C.

17. The method according to any one of the preceding claims, **characterized in that** peak lists are produced from the NMR spectra to define the signal groups.

18. The method according to claim 17, **characterized in that** a data point of the preferably two-dimensional NMR spectrum is recognized as "peak" when its value is larger than that of n neighboring data points, wherein preferably n=8.

19. The method according to any one of the claims 17 or 18, **characterized in that** neighboring peaks are combined to clusters and are evaluated using cluster analysis, wherein one or more clusters are assigned to the respective sub-structures as signal groups.

20. The method according to claim 19, **characterized in that** each cluster is assigned with a region in the NMR spectrum, and one sub-structure is regarded as being detected when the NMR signal integrated over the assigned regions exceeds a predetermined threshold value for all assigned regions.

21. The method according to claim 20, **characterized in that** the threshold value is proportional to the integral of the NMR signal over regions which are assigned to other sub-structures.

## Revendications

1. Procédé pour vérifier la synthèse de molécules organiques de la chimie combinatoire constituées de sous-structures, qui comprend les étapes suivantes :
(A) mise à disposition des sous-structures nécessaires pour la synthèse des molécules organiques et attribution de codes de sous-structure (Aₓ, B_{y}, C_{z}) ;
(B) synthèse d'une série combinatoire de molécules organiques, qui contiennent ces sous-structures, par combinaison systématique de différentes sous-structures et chaque fois, attribution d'un code global (AₓB_{y}C_{z}) à chaque combinaison ;
(C) enregistrement ou acquisition de spectres RMN des molécules organiques synthétisées de sorte qu'au moins pour une quantité partielle des combinaisons réalisées à l'étape (B), un spectre RMN est enregistré ou acquis ; **caractérisé en ce que** le procédé comprend en outre, les étapes suivantes :
(D) attribution univoque de groupes de signaux des spectres RMN à chaque sous-structure individuelle par addition et soustraction formelles des spectres RMN enregistrés ou acquis à l'étape (C), de sorte que l'on obtienne par les addition et soustraction formelles, un spectre RMN pour chaque sous-structure, qui ne contient que les groupes de signaux de chaque sous-structure ;
(E) vérification des spectres RMN des combinaisons, où dans la vérification, on vérifie le spectre RMN de chaque combinaison pour ou quant à la présence de tous les groupes de signaux du code global attribué à chaque combinaison, à l'aide de l'attribution univoque produite à l'étape (D) ;
(F) si la vérification de l'étape (E) montre que l'on observe précisément ou exactement dans le spectre RMN de chaque combinaison, les groupes de signaux, qui sont contenus dans le code global de la combinaison respective, la combinaison est **caractérisée** de « vraie ».

2. Procédé selon la revendication 1, **caractérisé en ce que** se raccorde l'étape (G) :
(G) si la vérification de l'étape (E) montre pour une certaine combinaison, que l'on n'observe pas dans le spectre RMN de la combinaison respective, au moins un groupe de signaux d'une sous-structure, qui est présente dans le code global de la combinaison, la combinaison est **caractérisée** de « fausse ».

3. Procédé selon la revendication 2, **caractérisé en ce que** se raccorde l'étape (H) :
(H) si la vérification selon l'étape (E) pour une certaine combinaison montre que ni (F), ni (G) ne s'applique, la combinaison est **caractérisée** de « non claire » ou « ambiguë ».

4. Procédé selon l'une des revendications précédentes, **caractérisé en ce que**
(D1') le choix d'une série représentative de combinaisons est réalisé, où la série représentative de combinaisons contient au moins une fois, toutes les sous-structures présentes ;
(D2') l'attribution univoque selon l'étape (D) est réalisée à l'aide des spectres RMN de la série représentative de combinaisons ;
(D3') le choix d'une série représentative modifiée de combinaisons et répétition à partir de l'étape (D2') si chaque sous-structure ne peut pas être attribuée de manière univoque à un groupe de signaux, et
(E') la vérification selon l'étape (E) pour les combinaisons restantes, n'appartenant pas à la série représentative est effectuée.

5. Procédé selon la revendication 4, **caractérisé en ce que** la série représentative à l'étape (D1') est dérivé de la modification d'une série représentative de combinaisons d'une série précédente de mesures.

6. Procédé selon la revendication 4 ou 5, **caractérisé en ce que** le nombre de combinaisons présentes dans la série représentative est minimisé.

7. Procédé selon l'une des revendications 4 à 6, **caractérisé en ce que** l'attribution à l'étape (D2') est réalisée manuellement.

8. Procédé selon l'une des revendications 4 à 6, **caractérisé en ce que** l'attribution à l'étape (D2') est réalisée automatiquement à l'aide d'un calculateur.

9. Procédé selon l'une des revendications précédentes, **caractérisé en ce que** les molécules organiques sont de faibles poids moléculaire, de préférence avec des poids moléculaires allant de 100 u à 2000 u.

10. Procédé selon l'une des revendications précédentes, **caractérisé en ce qu'**une partie de la molécule organique globale (= coeur) est présente de manière identique dans toutes les combinaisons.

11. Procédé selon la revendication 10, **caractérisé en ce que** le coeur est une sous-structure, qui présente de deux à six sites de liaison chimique.

12. Procédé selon la revendication 10 ou 11, **caractérisé en ce que** les sous-structures sont rassemblées en groupes, qui sont attribués chaque fois, à un site de liaison du coeur.

13. Procédé selon l'une des revendications précédentes, **caractérisé en ce que** le nombre de sous-structures intéressantes se situe entre de cinq à cinq cents.

14. Procédé selon l'une des revendications précédentes, **caractérisé en ce que** le spectre RMN est à une dimension.

15. Procédé selon l'une des revendications précédentes, **caractérisé en ce que** le spectre de RMN est un spectre à deux dimensions, de préférence un spectre HSQC (heteronuclear single quantum coherence).

16. Procédé selon l'une des revendications précédentes, **caractérisé en ce que** le spectre RMN comprend les noyaux atomiques ¹H et ¹³C.

17. Procédé selon l'une des revendications précédentes, **caractérisé en ce qu'**à partir des spectres RMN, on établit des listes de pics pour la définition des groupes de signaux.

18. Procédé selon la revendication 17, **caractérisé en ce qu'**un point de donnée du spectre RMN de préférence à deux dimensions, est reconnu en tant que « pic », lorsque sa valeur est supérieure à celle des n points de données voisins, où de préférence, n = 8.

19. Procédé selon la revendication 17 ou 18, **caractérisé en ce que** les pics voisins sont groupés en assemblages et évalués par analyse des assemblages, un ou plusieurs assemblages étant attribués aux groupes de signaux des différentes sous-structures.

20. Procédé selon la revendication 19, **caractérisé en ce qu'**à chaque assemblage est attribué une zone du spectre RMN et qu'une sous-structure est considéré comme étant reconnue lorsque pour toutes les zones qui lui sont attribuées, le signal RMN intégré sur les zones attribuées dépasse une valeur seuil donnée.

21. Procédé selon la revendication 20, **caractérisé en ce que** la valeur seuil est proportionnelle à l'intégrale du signal RMN sur les zones, qui ont été attribuées à d'autres sous-structures.
